# EUROPEAN PATENT APPLICATION

(11) **EP 1 207 555 A1**
(43) Date of publication of application: **22.05.2002**
(21) Application number: 01000626.0
(22) Date of filing: 14.11.2001
(51) Int. Cl.: H01L 23/498, H01L 23/31

(54) **Flip-chip on film assembly for ball grid array packages**

(30) Priority: 16.11.2000 US 249385 P
(71) Applicant: Texas Instruments Incorporated, Dallas, Texas 75251 (US)
(72) Inventor: Coyle, Anthony L., Plano TX, 75074 (US); Buschbom, Milton L., Plano TX, 75074 (US)
(74) Representative: Holt, Michael

(57) **Abstract**

The structure and method of a Ball-Grid Array or Land-Grid Array plastic integrated circuit (IC) device 100 are described, which have gold bumps 106 on the chip contact pads 105, spaced apart by less than 100µm center to center, flip-chip attached to a thin-film plastic substrate 101. An overmold package 109 provides stability for solder ball attachment to outside parts. An optional non-conductive polymer adhesive, used as a bump underfill, provides additional package rigidity.

## Description

### TECHNICAL FIELD OF THE INVENTION

The present invention is related in general to the field of semiconductor devices and processes, and more specifically to structure and processes of Ball Grid Array packages having flip-chip on film assemblies.

### DESCRIPTION OF THE RELATED ART

The growing popularity of flip-chip assembly in the fabrication process flow of silicon integrated circuit (IC) devices is driven by several facts. First, the electrical performance of the semiconductor devices can be improved when the parasitic inductances correlated with conventional wire bonding interconnection techniques are reduced. Second, flip-chip assembly provides higher interconnection densities between chip and package than wire bonding. Third, flip-chip assembly consumes less silicon "real estate" than wire bonding, and thus helps to conserve silicon area and reduce device cost. And fourth, the fabrication cost can be reduced, when concurrent gang-bonding techniques are employed rather than consecutive individual bonding steps.

The conventional fabrication process uses solder balls and their reflow technique as the standard method of ball bonding. While tin/lead alloys have been widely accepted as material for the solder balls, the contact pads of the IC chip have to receive special metallization for successful metallurgical attachment of the solder balls. Structure and preparation of metallization and solder, as well as reliability aspects of the contacts, have been described in numerous publications, most notably in the trail-blazing set of papers in the IBM J. Res. Develop., vol. 13, pp. 226-296, 1969: 226 - 296), defining the so-called "C-4" technique: P.
A. Totta et al., "SLT Device Metallurgy and its Monolithic Extension", L.F. Miller, "Controlled Collapse Reflow Chip Joining", L.S. Goldmann, "Geometric Optimization of Controlled Collapse Interconnections", K.C. Norris et al., "Reliability of Controlled Collapse Interconnections", S. Oktay, "Parametric Study of Temperature Profiles in Chips Joined by Controlled Collapse Techniques", B.S. Berry et al., "Studies of the SLT Chip Terminal Metallurgy".

In known technology, however, the achievable bump pitch is limited. For solder materials, bumps or balls are presently limited to 160µm pitch. These limits severely restrict the number of connections that can be made on the available chip surface, and constrain the use of flip-chip techniques for devices having small integrated circuit (IC) chips.

Efforts were undertaken later to replace solder-based interconnecting balls with gold bumps. Major progress was achieved in attaching metal leads (for example, copper or tin-plated copper) to gold bumps by the so-called "tape-automated bonding" (TAB) technique. This technique, however, gained only limited acceptance due to its high relative cost compared to conventional wire ball bonding or solder reflow bonding. The manufacturing cost was not substantially lowered by an effort to create gold bumps by a modified wire ball technique. In this technique, the bumps are allowed to retain a small "tail" which is formed when the gold wire is broken off after the free air ball has been formed and pressured as a "bump" against the substrate. For gold stud bumps or gold-plated bumps, 25µm diameter is the lower value for devices in production presently.

In later years, the substrates to which the IC chips are to be flip-bonded have been changed from ceramic to organic, such as printed circuit boards (for instance, FR-4) or a polyimide-based foil. In U.S. Patent # 5,928,458, issued on Jul. 27, 1999 (Aschenbrenner et al., "Flip-Chip Bonding with Non-Conductive Adhesive), an approach is described to combine a modified gold bump technique, based on the above-described wire ball method, with a flexible organic substrate for flip-chip assembly. A non-conductive adhesive, made of a thermosetting or thermoplastic blend, is used to stabilize the gold bumps against the mechanical stress encountered in temperature cycling testing. Since the "bumps" are created one by one, this approach is not cost effective for mass production. It also does not lend itself easily for a small, chip-scale device.

An urgent need has therefore arisen for a coherent, low-cost method of assembling high lead count, yet chip-scale device which can be adopted for solder attachment to circuit boards, similar to a ball-grid array package. The device should further have excellent electrical performance, mechanical stability, and high product reliability. The fabrication method should be flexible enough to be applied for different semiconductor product families and a wide spectrum of design and process variations. Preferably, these innovations should be accomplished while shortening production cycle time and increasing throughput, and using the installed equipment base so that no investment in new manufacturing machines is needed.

### SUMMARY OF THE INVENTION

The structure and method of a Ball-Grid Array or Land-Grid Array plastic integrated circuit (IC) device are described, which have gold bumps on the chip contact pads, spaced apart by less than 100µm center to center, flip-chip attached to a thin-film plastic substrate. An overmold package provides stability for solder ball attachment to outside parts. An optional non-conductive polymer adhesive, used as a bump underfill, provides additional package rigidity.

The invention describes a semiconductor device, which comprises an IC chip having an outline, active and passive surfaces, and active components including a plurality of fine-pitch contact pads on the active surface. The device further comprises a plurality of electrical coupling members attached to the contact pads (the coupling members are selected from a group consisting of gold bumps, copper bumps, copper/nickel/palladium bumps, and z-axis conductive epoxy). The device further comprises an electrically insulating thin-film interposer having first and second surfaces, a plurality of electrically conductive lines integral with the first surface, a plurality of electrically conductive paths extending through the interposer, contacting the conductive lines and forming exit ports on said second surface. The interposer has an outline substantially the same as the outline of the chip.

The chip coupling members are attached to the conductive lines so that the chip covers an area portion of the first interposer surface. Finally, encapsulation material protects the passive chip surface and at least a portion of the first interposer surface not covered by the attached chip.

In one embodiment of the invention, the device is fabricated as a Land-Grid Array, or Pad-Grid Array, package. By further attaching solder balls to the exit ports on the second interposer surface, the device becomes a Ball-Grid Array package, providing a second embodiment of the invention. While the invention is applicable to devices of any size, some devices of small geometries fit into the categories of chip-scale and chip-size packages.

In a third embodiment of the invention, the device has an adhesive non-conductive polymer, underfilling any spaces between the chip coupling members attached to the conductive lines under the chip; this feature adds further stability to the device.

It is an aspect of the present invention to provide a low-cost method and system for packaging high pin-count chip-scale devices in thin overall profile.

Another aspect of the present invention is to provide a high production throughput by employing gang-bonding techniques for thermo-compression bonding.

Another aspect of the invention is to improve electrical product performance by minimizing parasitic resistances and inductances.

Another aspect of the invention is to provide high quality control and reliability assurance through in-process control at no extra cost.

The invention introduces assembly concepts for thin profiles and reliability which are flexible so that they can be applied to many families of semiconductor products, and are general so that they can be applied to several future generations of products. Furthermore, the invention minimizes the cost of capital investment and the movement of parts and product in the equipment.

These aspects have been achieved by the teachings of the invention concerning design concepts and process flow suitable for mass production. Various modifications have been successfully employed to satisfy different selections of product geometries and materials.

### BRIEF DESCRIPTION OF THE DRAWINGS

For a more complete understanding of the present invention, reference is now made to the following detailed description of certain particular and illustrative embodiments and the features and aspects thereof, by way of example only, and with reference to the figures of the accompanying drawings in which:
FIGURE 1 is a simplified and schematic cross section of a Ball-Grid Array device;
FIGURES 2A-2B, 3A-3B, 4A-4B, 5A-5B, & 6A-6B show schematically both top views and cross sections of a Land-Grid array device, at significant steps of the device assembly process;

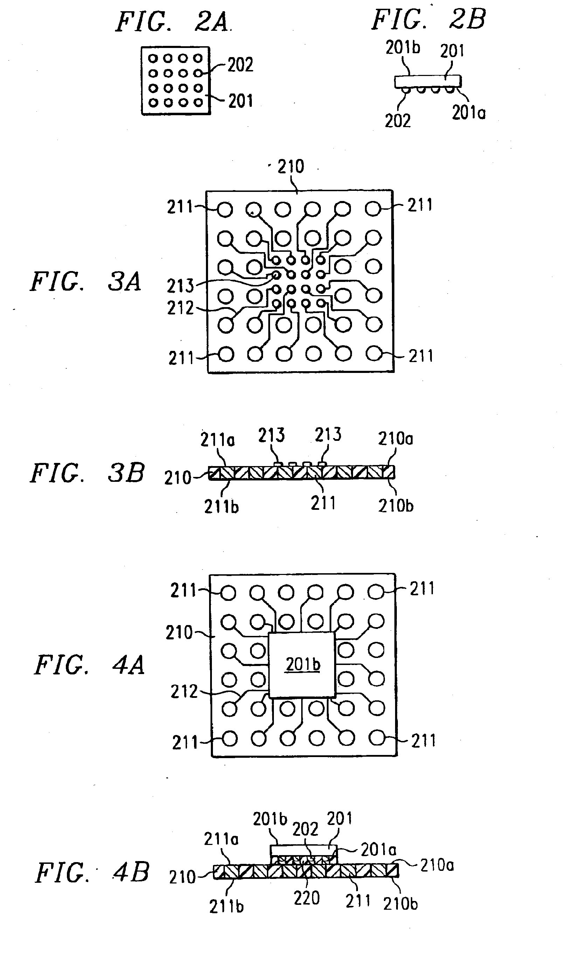

FIGURES 2A & 2B illustrate an IC chip with gold bumps;
FIGURES 3A & 3B illustrate a thin film interposer;
FIGURES 4A & 4B illustrate a process for attaching a bumped chip to an interposer;

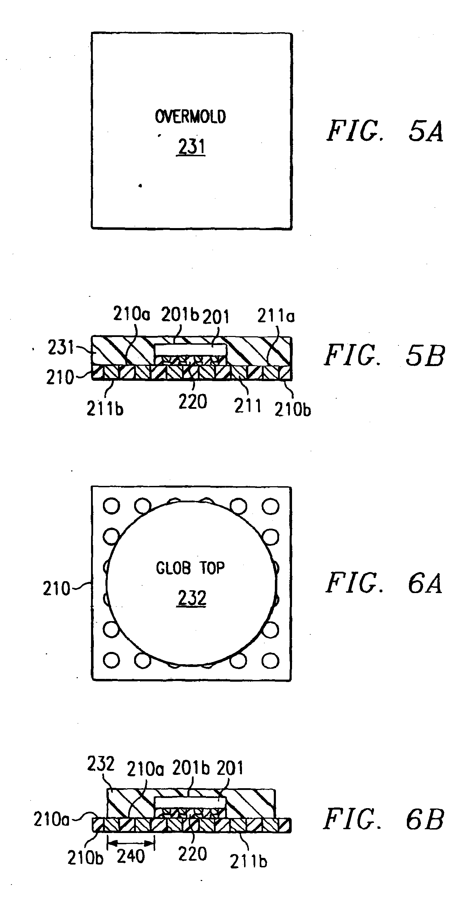

FIGURES 5A & 5B illustrate a process for encapsulating with an overmold; and
FIGURES 6A & 6B illustrates the process of encapsulating by glob top.

### DETAILED DESCRIPTION OF PREFERRED EMBODIMENTS

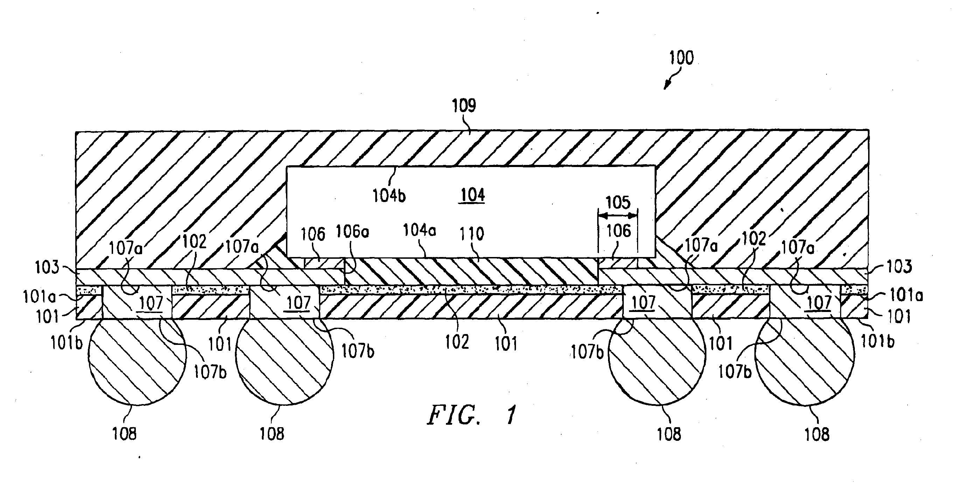

FIG. 1 illustrates, in schematic and simplified fashion, the cross section through a device, generally designated 100, in the configuration of a Ball-Grid Array package. The invention, however, is generic; this means, slight variations in processing (discussed below) can specialize the device as a Land-Grid array, Pad-Grid Array, or modified Pin-Grid Array).

The device 100 is depicted as having a low profile package. As defined herein, the term "profile" refers to the thickness or height of the integrated circuit package. This definition does include the height of the solder balls before they are reflown in board attachment. The invention applies to devices of any outline, including to those having a chip-scale or chip-size package outline. As defined herein, the term "outline" relates to the overall width and length of the integrated circuit (IC) package. The outline of the package is also referred to as the footprint of the package, because it defines the surface area on a wiring or assembly board that the package will occupy. The invention relates to packages of all sizes or ratios of chip outline versus package outline. Consequently, the invention also relates to small outline packages such as so-called chip-scale and chip-size packages.

In FIG. 1, the Ball-Grid Array chip-scale device 100 is shown with a structure similar to the MicroStarJunior™ package fabricated by Texas Instruments, Dallas, Texas, U.S.A. An important part of this package is the thin-film interposer 101. This baseline polymer film 101 (for example, polyimide) is punched with an outline needed for accommodating the number of contact "lands" of "solder balls" serving the attachment to outside parts. For some devices, this means adding typically less than 20% to the outline of the silicon chip area. For some other device types, the baseline film may have to be substantially larger than the chip outline to accommodate large pin-count chips. The baseline film 101 is made of electrically insulating materials such as polyimide, preferably in the thickness range from about 40 to 80µm; in some instances, it may be thicker. Other suitable materials include Kapton™, Upilex™, PCB resin, FR-4 (which is an epoxy resin), or a cyanate ester resin (sometimes reinforced with a woven glass cloth). These materials are commercially available from several sources; as examples, in the U.S.A., companies include 3-M, DuPont, and Sheldahl; in Japan, Shinko, Shindo, Sumitomo, and Mitsui, and Ube Industries Ltd; and in Hong Kong, Compass.

The interposer 101 has a first surface 101a and a second surface 101b. On the first surface 101a is an adhesive layer 102, and adhering to it is the metal foil 103. A plurality of electrically conductive lines is formed from foil 103. In addition, other structures of passive electrical components could be formed from this foil. Examples are resistors, inductors, distributed components, and a network of passive components and interconnected structures. It is within the scope of the invention that at least portions of these passive structures (for instance, inductors and capacitors) may be positioned under the IC chip.

The thickness of the metal foil 103 is preferably between about 15 and 40µm. Preferred foil materials include copper, copper alloys, gold, silver, palladium, platinum, and stacked layers of nickel/gold and nickel/palladium. The thickness of the adhesive layer 102 is typically between 8 and 15µm. The number and the width of the metal lines is, obviously, a function of the number and the pitch of the coupling members attached to the contact pads of the chip. If the metal lines are fabricated from a foil, etching is the preferred method of production. It the metal lines are deposited, a plate-up process is advantageous.

The IC chip 104 has an outline and a profile, which determine in first order the outline and profile of device 100. The chip profile (thickness) may vary from 130 to 375µm; the majority of chips presently falls in the 250 to 375µm thickness range. The chip outline may vary from about 0.2 to 22mm. The package outline may vary from about 1.5mm per side (for square-shaped chips) to 50mm; elongated or rectangular-shaped chips and packages are common.

Chip 104 has an active surface 104a and a passive surface 104b. Active components, forming the IC, are fabricated in active surface 104a, including a plurality of contact pads 105. Dependent on the many different semiconductor device types, to which this invention is applicable, the number of contact pads varies widely, from 3 to more than 3000. Presently, the majority of chips has contact pads numbering in the 30 to 600 range.

While the present invention can be applied to any pitch of the contact pads 105, it is important to the invention that the contact pads 105 may be spaced apart from each other by less than 100µm, center to center. In other words, while the invention applies to any, even relatively low pin count of the devices, the full impact and benefit of the invention is revealed in the category of relatively high and very high pin count devices. In a flip-chip arrangement, these contact pads can utilize the whole chip area for input/output purposes. Due to these fine-pitch contact pads, the chip area required even for a high number of inputs/outputs can be kept to a minimum.

The electrical coupling members 106 attached to these contact pads are adjusted for the small pad pitch. Preferably, the coupling members are metal bumps selected from a group consisting of gold, copper, copper alloy, or layered copper/nickel/palladium. Another option is z-axis conductive epoxy. The bumps may have various shapes, for example rectangular, square, round, or half-dome. The cross section of bump 106 in Fig. 1 applies to several shape options of these coupling members.

Deposition methods for gold bumps on conventional aluminum metallization of the chip contact pads have been described in the technical literature. The most common method is electroplating; however, electroless deposition is also used. Deposition methods of bumps on the more recent copper metallization of the chip contact pads are preferring layered bumps, such as copper/nickel/palladium. Successful techniques have been described in U.S. Patent Applications # 60/183,405, filed on 02/18/2000 (Stierman et al., "Structure and Method for Bond Pads of Copper-Metallized Integrated Circuits"), and # 09/611,623, filed on 07/07/2000 (Shen et al., "Integrated Circuit with Bonding Layer over Active Circuitry"). The methods of these Applications are hereby incorporated by reference.

The method of attaching the coupling members 106 to the conductive lines 103 is a thermo-compression bonding technique based on metal interdiffusion, as has been practiced previously in the tape-automated-bonding (TAB) fabrication method. The preferred technique for the present invention is a gang-bonding technique for array assembly. This technique has the advantage of fast and low-cost operation while resulting in high quality, reliable attachments. The automated apparatus is commercially available from Shinkawa Corporation, Japan.

As indicated in FIG. 1, the electrically insulating thin-film interposer 101 has a plurality of electrically conductive paths 107 extending through the interposer 101, from its first surface 101a to its second surface 101b. These paths are created by opening vias through interposer 101 (using an etching, laser, or punching technique) and filling these vias either with solderable metal or solder. A suitable fabrication method has been described in U.S. Patent Application Serial Numbers 60/204,262, 60/244,673, 09/855,879 respectively submitted on 15/05/2000, 31/10/2000, 15/05/2001 (Pritchett et al., "Plastic Chip-Scale Package having Integrated Passive Components"), which is hereby incorporated by reference.

The conductive paths 107 contact the conductive lines 103 at the interfaces 107a. At the second surface 101b of the interposer 101, the paths 107 form exit ports 107b. As FIG. 1 shows for Ball-Grid Array devices, there may be solder balls 108 attached to these exit ports 107b. For Land-Grid Array devices, these solder balls would not be necessary.

As defined herein, the term solder "ball" does not necessarily imply that the solder contacts are necessarily spherical. They may have various forms, such as semispherical, half-dome, truncated cone, or generally bump. The exact shape is a function of the deposition technique (such as evaporation, plating, or prefabricated units), reflow technique (such as infrared or radiant heat), and material composition. Solder balls may be selected from a group consisting of pure tin, tin alloys including tin/copper, tin/indium, tin/silver, tin/bismuth, tin/lead, and conductive adhesive compounds.

As shown in FIG. 1, it is an important aspect of the present invention to create a composite structure having rigidity by encapsulating chip 104 and at least a portion of the adjacent interposer 103. The embodiment of FIG. 1 illustrates the example of an overmolded device. Using well-known transfer molding techniques and molding compounds (usually an epoxy base material of suitable polymerization characteristics, glass transition temperature, and stabilizing inorganic fillers), the encapsulation 109 is created with a thickness appropriate for the desired profile of the overall device. For Land-Grid Array packages, the device profile is in the range from about 0.2 to 1.0mm, for Ball-Grid Array packages, as shown in FIG. 1, the thickness of the attached solder material has to be added.

In the embodiment of FIG. 1, the encapsulation surrounds and protects the passive surface 104b of chip 104 and all area of the first interposer surface 101a with its integrated electrically conductive lines 103. In another embodiment of the invention, shown in Figures 6A & 6B, a glob top encapsulation covers only a central portion of the device, yet enough area to provide stability to the device.

FIG. 1 illustrates the option to underfill the bump-attached chip with material 110. The preferred choice for the underfill material 110 is a non-conductive, adhesive polymer such as an insulating, adhesive thermoplastic/thermosetting blend without conductive fillers/particles. An example are epoxy-based potting materials available from vendors such as Hitachi Chemical, Toshiba Chemical, and Namics, all of Japan.

The method of fabricating an embodiment of the present invention is illustrated in Figures 2A-2B, 3A-3B, 4A-4B, 5A-5B, and 6A-6B for a schematic Land-Grid Array structure. Each significant process step is shown by both a (simplified) top view and a (simplified) cross sectional view.

Figures 2A & 2B depict a top view and a cross section of an IC chip 201 with coupling members 202 (for example, gold bumps) attached. The chip as depicted in Figures 2A & 2B has been formed by a number of preceding process steps, which are well established in the industry and therefore not shown in Figures 2A & 2B. These process steps are performed on a whole semiconductor wafer in a wafer fab. For the present invention, the following process steps are especially significant:
* Depositing an electrical coupling member of gold, copper, or copper/nickel/palladium on each contact pad of each IC chip on the wafer, each chip having pads spaced apart by less than 100 µm, center to center. The contact pads of the IC are located on active surface 201a of the chip.
* mounting the semiconductor wafer on a mounting tape, held tight in a solid frame, in preparation for chip singulation (sawing);
* sawing the wafer into discrete chips; and
* UV curing the mounting tape for releasing the sawed chips from the mounting tape.

Figures 3A & 3B depict a top view and a cross section of an electrically insulating thin-film interposer as prepared from the materials and process steps explained above. In particular, the electrically insulating film 210 has a plurality of electrically conductive paths 211 through the thickness of the interposer from the first surface 210a to the second surface 210b, further a plurality of electrically conductive lines 212 on the first surface. The interposer further has a plurality of patterned attachment sites 213 on the first surface, which match the pattern of the coupling members (gold bumps) on the IC chip. The fabrication steps of the thin-film interposer include the following major steps:
* Depositing and patterning a plurality of electrically conductive lines 212 and attachment sites 213 on the first surface 210a of the interposer; and
* forming a plurality of electrically conductive paths 211 through the interposer. These paths 211 are contacting the conductive lines at the first interposer surface (211a) and form exit ports on the second interposer surface (211b).

Figures 4A & 4B illustrates the assembly process step of IC chip and interposer. The top view of Figures 4A & 4B shows the passive surface 201b of the chip after assembly onto the interposer 210, while the active chip surface 201a faces the first surface 210a of the interposer (flip-chip assembly). This important process step comprises:
* assembling the active chip surface 201a onto the first interposer surface 210a such that each of the chip coupling members 202 is aligned and brought into contact with the respective attachment site 213 of the interposer; and
* using thermo-compression gang bonding, all contact connections are created essentially concurrently by metal interdiffusion. A chip-size portion of the interposer is thus covered by the assembled chip 201.
An optional process step comprises:
* Underfilling an adhesive polymer 220 into any spaces under the chip between the chip coupling members 202; these spaces have been formed by the process step of assembling chip 201 onto the interposer 210. The underfill material strengthens the assembly.

In a variation of the above process flow, the underfill material may be applied prior to the thermo-compression bonding process step.

Figures 5A-5B and 6A-6B illustrate the important process step of encapsulating the assembled device for creating a composite structure having rigidity. The process step comprises:
* Encapsulating, with a polymer compound, the passive surface 201b of the chip and at least a portion of the first interposer surface 210a which is not covered by the attached chip.
** If a transfer molding method is used, the molding compound 231 protects the first interposer surface 210a completely (Figures 5A & 5B). The outline of the molding compound thus defines the outline of the device. Transfer molding, including mold compound curing, is the preferred method, since it is a well-established and low-cost (batch process) technology.
** If a protection method by a glob top is used, the polymer material 232 covers only a portion of the first interposer surface 210a which is not covered by the attached chip. That surface portion is marked 240 in Figures 6A & 6B. The glob top may be round, as shown in Figures 6a & 6B, or have any other desired outline (for instance, square or rectangular).

After the step of encapsulating follows the step of:
* separating the resulting composite structure into discrete units. A preferred method is sawing. The resulting device outline may be that of a generic Ball-Grid Array device, or a more specific chip-scale or chip-size device.

The final devices as depicted in Figures 5A-5B and 6A-6B belong into the category of Land-Grid Array devices. In order to fabricate a Ball-Grid Array device, an additional process step is performed as:
* attaching solder balls to the exit ports 211b on the second interposer surface 210b. Preferably, this process step is performed, before the above step of separating is executed.

The following process steps are analogous to known fabrication techniques:
■ Marking;
■ Testing;
■ Visual/mechanical inspecting;
■ Interposer editing;
■ Packing; and
■ Shipping.

While this invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description. As an example, the method of providing gold bumps to the IC chip for connection to the interposer may be replaced by a method of providing a z-axis conductive epoxy. As another example, the interposer may comprise two or three layers of electrically insulating and conductive materials. As yet another example, the semiconductor chip material may be silicon, silicon germanium, gallium arsenide, or any other semiconductor material employed for mass production.

## Claims

1. A semiconductor device comprising:
an integrated circuit chip having an outline, active and passive surfaces, and active components including a plurality of contact pads on said active surface;
a plurality of electrical coupling members attached to said contact pads, said coupling members selected from a group consisting of gold bumps, copper bumps, copper/nickel/palladium bumps, and z-axis conductive epoxy;
an electrically insulating thin-film interposer having first and second surfaces, a plurality of electrically conductive lines integral with said first surface, a plurality of electrically conductive paths extending through said interposer, contacting said conductive lines and forming exit ports on said second surface;
said chip coupling members attached to said conductive lines, covering an area portion of said first interposer surface; and
encapsulation material protecting said passive chip surface and at least a portion of said first interposer surface not covered by said attached chip.

2. The device according to Claim 1, wherein said contact pads are spaced apart by less than 100µm center to center.

3. The device according to Claim 1 or Claim 2, further comprising:
solder balls attached to said exit ports on said second interposer surface.

4. The device according to any of Claims 1-3, further comprising:
an adhesive non-conductive polymer underfilling any spaces between said chip coupling members attached to said conductive lines under said chip.

5. The device according to any of Claims 1-4, wherein said interposer comprises a polyimide film.

6. The device according to any of Claims 1-5, wherein said interposer has an outline larger than said outline of said chip.

7. The device according to any of Claims 1-6, wherein said electrically conductive lines are made of a material selected from a group consisting of copper, copper alloy, or copper plated with tin, tin alloy, silver, or gold.

8. The device according to any of Claims 1-7, wherein said coupling member attachment is provided by metal interdiffusion of thermo-compression bonding.

9. The device according to any of Claims 1-8, wherein said encapsulation material comprises a molding compound.

10. The device according to Claim 9, wherein said molding compound has the same outline as said interposer.

11. A method of assembling an integrated circuit device, comprising:
depositing an electrical coupling member of gold, copper, or copper/nickel/palladium on each contact pad of a circuit chip;
forming an electrically insulating thin-film interposer by depositing and patterning a plurality of electrically conductive lines on a first surface thereof;
creating a plurality of electrically conductive paths extending through said interposer;
contacting said conductive lines on said first surface and forming exit ports on a second surface of said interposer;
assembling the active surface of said chip onto said first interposer surface such that each of said coupling members is attached to one of said lines, respectively, thereby covering an area portion of said first interposer surface;
encapsulating, with a polymer compound, the passive surface of said chip and at least a portion of said interposer surface not covered by said attached chip, thereby creating a composite structure having rigidity; and
separating the resulting composite structure into discrete units.

12. The method according to Claim 11, wherein depositing an electrical coupling member on each contact pad of a circuit chip having pads spaced apart by less than 100µm, center to center.

13. The method according to Claim 11 or Claim 12, further comprising:
underfilling an adhesive non-conductive polymer into any spaces between said chip coupling members under said chip, which have been formed by assembling said chip onto said interposer, thereby strengthening said assembly.

14. The method according to any of Claims 11-13 further comprising:
attaching solder balls to said exit ports on said second interposer surface, after completing said encapsulating and before said separating.

15. The method according to any of Claims 11-14, wherein depositing comprises plating, electro-plating, sputtering, or evaporating.

16. The method according to any of Claims 11-15, wherein separating comprises the singulating, trimming and forming said composite structure.

17. The method according to any of Claims 11-16, wherein assembling comprises the method of thermo-compression gang bonding said chip coupling members onto said interposer lines.
